# EUROPEAN PATENT SPECIFICATION

(11) **EP 0 810 914 B1**
(45) Date of publication and mention of the grant of the patent: **07.10.1998**
(21) Application number: 96904676.2
(22) Date of filing: 22.02.1996
(51) Int. Cl.: B26D 5/32, B26D 5/00, B26D 7/01, B26F 1/00, B26F 1/04, G03F 9/00

(54) **A METHOD AND A DEVICE FOR APPLYING PERFORATIONS**
VERFAHREN SOWIE VORRICHTUNG ZUM PERFORIEREN
PROCEDE ET DISPOSITIF POUR LA FORMATION DE PERFORATIONS

(30) Priority: 22.02.1995 BE 9500157; 15.06.1995 BE 9500532
(43) Date of publication of application: 10.12.1997
(73) Proprietor: Barco Graphics, 9052 Zwijnaarde (BE)
(72) Inventor: VAN PARYS, Frank, B-9000 Gent (BE)
(86) International application number: BE9600018
(87) International publication number: WO9626047

(56) References cited:
- EP-A- 0 367 185
- DE-C- 3 439 770
- US-A- 3 368 439

## Description

The invention relates to a method for applying perforations in a printed or exposed carrier, wherein at least a first and a second register mark are applied on the carrier, and wherein the carrier and a perforation member are positioned with respect to each other by means of the first and the second register mark, whereafter at least one perforation is applied in the carrier by means of the perforation member.

The invention also relates to a device for applying perforations in a printed or exposed carrier. Such a device is characterised in that it comprises a supply opening for supplying the carrier, a perforation member and a detection member provided for detecting a first and a second register mark applied on the carrier, and for positioning the carrier and the perforation member with respect to each other.

Such a method and a device are known from US-A-3,368,439 and is applied in the graphic industry for printing, copying or exposing carriers formed of plates or foil. Since the exposure, copying or printing are often dealt with in several phases, it is necessary to correctly position the plate or the folio at each phase. Therefor one or more holes are punched in the carrier. The punching occurs each time after that the first and second register mark on the carrier are recognised and that the perforation member is positioned with respect to these register marks. The positioning of the perforation member with respect to the register marks occurs visually by means of a microscope that is coupled with the perforation member.

A drawback of the known method is that it is not very suitable for "on-line" application of perforations. The displacement of the microscopes is indeed laborious. Furthermore the perforation member is only provided with one perforation element whereby the same perforation format (shape) is each time applied. To apply a perforation of another format the whole element has to be changed which is again laborious.

The object of the invention is to realise a method for applying perforations in a carrier whereby perforations of different pattern are on-line applied. According to the invention the method defined in the preamble of claim 1 is characterised in that a codeword, which indicates for each perforation to be applied the format of that perforation, is read before the perforation is applied and wherein after reading the codeword a perforation head is selected from the perforation member which corresponds with the format for the perforation to be applied indicated in the codeword. Because the codeword comprises the format of the perforation to be applied and because the format supplied in the codeword is selected it is possible to apply on-line perforations of different format in the carrier. The presence of several perforation heads in the perforation member moreover allows such a selection. Because the perforations are each time applied after accurate positioning with respect to the nearby register marks deformations in the carrier will also not exert any negative influence.

It should be noticed that the use of a codeword for applying perforations is known from DE-C-3439770. The codeword used there does not comprise the format of the perforation to be applied and is used more as a location indication. Moreover in this German patent text the codeword itself is formed by perforations or in any other way, for example by printing, impressing or carving, because it is used in a profiling machine that processes profiles. Such profiles clearly differ from an exposed or printed carrier.

A first preferred embodiment of a method according to the invention is characterised in that for each perforation to be applied a position information is each time present in the codeword, which position information indicates where the perforation has to be applied. This renders the detection of the first register marks simpler as well as the positioning of the perforation member and carrier.

It is favourable that said codeword is applied on the carrier. The risk of false information is hereby minimal and moreover there is a single unambiguous relation between carrier and codeword.

A second preferred embodiment of a method according to the invention is characterised in that said first register mark is each time applied on a distance of at the most 50 mm of the perforation to be applied. Hereby possible deformations in the carrier that are the consequence of temperature and humidity fluctuations are taken into consideration. In that way perforations are applied each time on or in the neighbourhood of the register mark whereby deformations do not have any influence any more, since the register mark has to be applied with great accuracy upon exposure.

A third preferred embodiment of a method according to the invention is characterised in that at the beginning of the carrier an indicator is applied which indicates the origin of a reference frame of the carrier and wherein the codeword is applied on a predetermined location with respect to that reference frame, and wherein upon introducing the carrier said indicator is recognised before reading the codeword. Such an indicator is quickly "on-line" recognised. Since the codeword is applied on a predetermined location indicator, the codeword is quickly searched after recognition of the indicator.

A fourth preferred embodiment of a method according to the invention is characterised in that said carrier is on-line supplied, the supply speed of the carrier being determined. The speed at which the perforations are applied on successive locations in the carrier is at the most set equal to the supply speed. It is hereby avoided that the carrier passes too quickly through the perforation member and thus pull on the carrier which would be a drawback for the developing process.

Furthermore, according to the invention, a device according to the preamble of claim 9 also comprises a codeword read-member provided for reading a codeword indicating the format of the perforation to be applied, the perforation member comprising at least two perforation heads, each adapted to apply a hole in the carrier which is of a format differing from the format which can be applied by using the other perforation head(s), which are selectable under control of the codeword. It also comprises a data processing unit to which the codeword read-member can transmit the codeword, the data processing unit being adapted to control the perforation member such that the carrier is perforated using a selected one of the perforation heads, the selection being carried out by processing of the codeword in the data processing unit. The invention will now be described in more detail by means of the embodiment represented in the drawings. In the drawings:
Figure 1 shows a top view of a possible embodiment of a device according to the invention;
Figure 2 shows the set-up of the detector and the perforation member;
Figure 3 respectively 4, shows a carrier before respectively after application of the method according to the invention;
Figure 5 shows an example of a carrier provided with a codeword and a first register mark;
Figure 6 shows an example of a carrier provided with a codeword and an applied perforation.

In the drawings a same reference number is attributed to a same or analogous element.

In the following description a punch machine is considered as embodiment. Other embodiments of a device for applying perforations are also possible. Thus the perforations can be applied for example by means of a laser beam, a water jet or by milling. The perforations are formed by holes applied through the carrier or by notches applied in the border of the carrier.

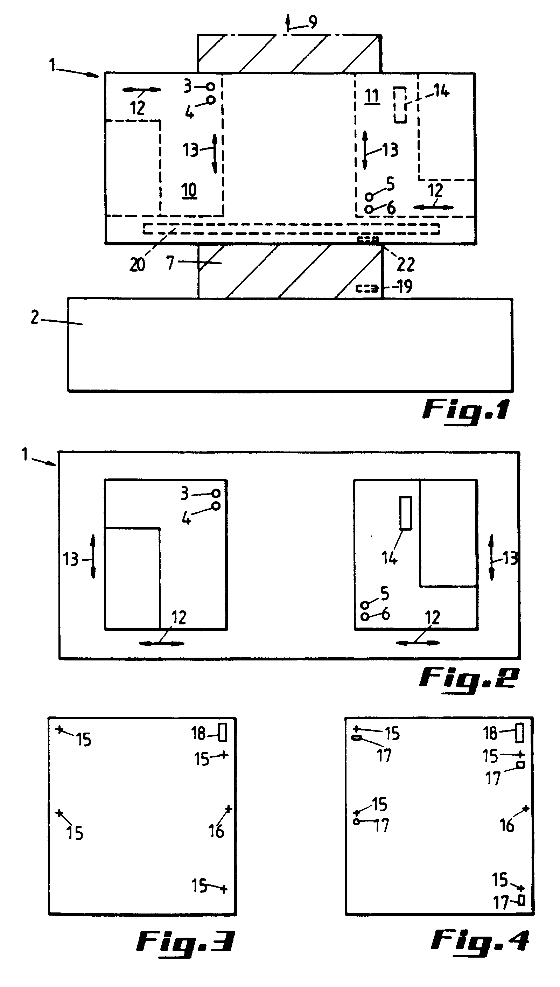

The punch machine 1 according to the invention, and represented in figure 1 has a supply opening (not represented) for supplying a carrier 7. This carrier 7 is for example formed by a plate or a folio, preferably a polyester folio. The printed or exposed carrier 7 is preferably pipelined or on-line supplied by a developing machine 2. The arrow 9 represents the transport direction of the carrier 7.

The punch machine 1 is provided with transport means for transporting the carrier 7 through the machine 1. These transport means are for example formed by a roller assembly 20. The roller assembly 20 is driven by a motor (not represented) whereof the speed is adjustable. Therefor a first detection cell 19 is applied at the output of the developing machine 2, for example a photocell, that supplies a first control pulse when the front of a carrier 7 comes by. Before the roller assembly 20, a second detection cell 22 is disposed at the entry of the punch machine 1, which is provided for generating a second control pulse when the front of an incoming carrier 7 enters the punch machine 1. The supply speed of the carrier 7 is determined from the time difference between the first and the second control pulse since the distance between the first detection cell 19 and the second detection cell 22 is known. This supply speed is thus equal to the speed with which the carrier 7 is delivered by the developing machine 2.

The supply speed is important for determining the speed with which the roller assembly 20 has to be driven and thus for the speed with which the successive perforations will be applied in the carrier 7. Indeed if the roller assembly 20 is driven at a higher speed than the supply speed, then the punch machine 1 would pull on the carrier 7 and thus disturb the development process in the developing machine 2 or even damage the carrier 7. To avoid this the speed of the carrier 7 in the punch machine 1 is determined in such a way that the latter equals at the most the supply speed.

The punch machine 1 moreover comprises a detection member formed by a first detector 3 and a second detector 5 as well as a perforation member formed by a first punch element 4 and a second punch element 6. The punch element 4 respectively 6 is associated with the detector 3 respectively 5.

Preferably the punch machine 1 contains two units 10, 11 whereof at least one is displaceable at least in transverse direction (arrow 12). Longitudinal displacement (arrow 13) is also possible, for example when the punch machine 1 operates on a stationary carrier 7. Transversal and/or longitudinal displacements make the punch machine 1 suitable to punch holes in carriers 7 of different formats. The units 10 and/or 11 are then displaced in such a way that the carrier 7 is adequately applied between them. The units 10 and/or 11 are thereto mounted for example on carriages and provided with propelling means that allow the displacement.

The punch elements 4, 6 preferably contain several perforation heads for punching each time a different format of hole. The different perforation heads of a same punch element 4, 6 are for example disposed side by side. In that disposition the punch elements 4, 6 must be shiftably disposed, for example by shifting the units 10 and 11, in order to position the selected perforation head adequately above the location that has to be punched. According to another embodiment the perforation heads are mounted on a rotating drum or a ring in order to make the selection of one of the heads possible by rotation and to maintain the mutual distance proportion between detector and perforation head.

Preferably the different perforation heads of a same punch element 4, 6 are mounted on a predetermined position in the element because an accurate positioning of the head with respect to a register mark is hereby possible. The different perforation heads are then selectively activated.

Since the carrier 7 is formed by a film or a plate, destined for being used in a printing process or a photographic process, it is important that the holes be punched at a correct location on the carrier 7. Deviations should preferably be smaller than 0.01 mm because otherwise printing errors can occur that are the consequence of shifts between the different colour prints or developments. If the carrier 7 is not adequately positioned upon every printing test because the holes were not sufficiently accurately punched, the different colours will not be printed on the adequate location whereby the whole colour impression will be disturbed. The relation between the carrier 7 and the picture applied thereon is important and can not be disturbed by positioning errors in the different impression or exposition phases.

It is thus important to apply the holes with a relatively great accuracy. Because moreover different formats of carriers 7 exist it is favourable to take this into consideration upon punching the holes without neglecting the accuracy with which the holes have to be applied.

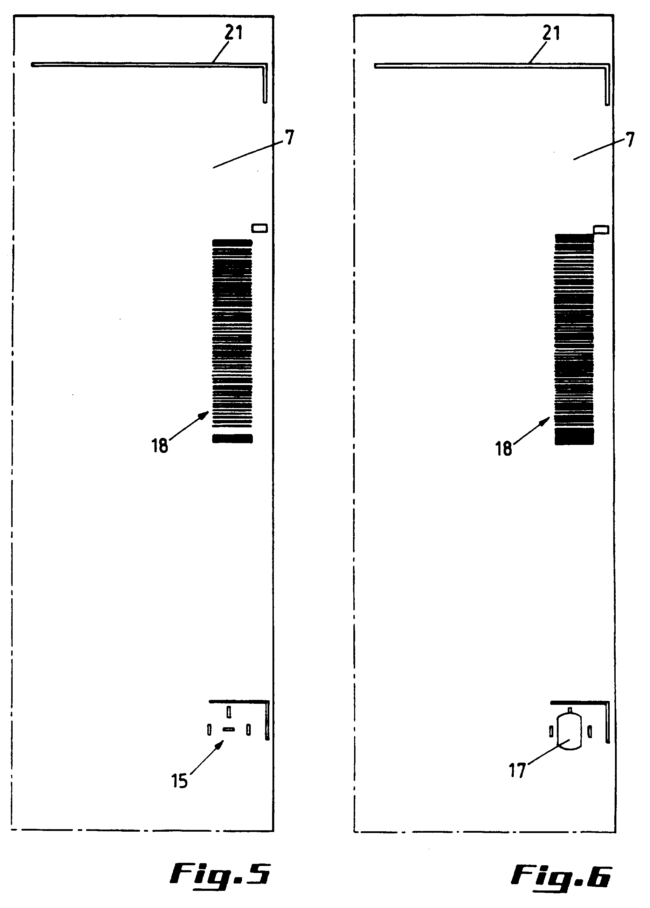

In order to identify the location where the holes have to be applied first register marks 15 are applied on the carrier 7 (figures 3 and 4). Moreover still a second register mark 16 per carrier 7 is applied. That second register mark 16 is preferably applied on the other border of the carrier 7 than the one whereon the first register mark 15 is applied. The second register mark 16 is necessary to make skewness corrections possible. Indeed if only the first register mark 15 is used for positioning an inaccuracy could still occur consequently to a rotation of the carrier 7.

A codeword 18 is further applied on the carrier 7, for example in the form of a barcode. This codeword 18 comprises amongst others information about the format of the different holes to punch in the carrier 7. Thus a well determined format per hole can be indicated. In figure 4 four different hole formats 17 (shapes) are thus represented. The codeword 18 comprises further for example information about the fact whether the carrier 7 has to be dealt in two or more parts, the place of the second register mark 16, the distance between successive first register marks 15, the format and type of carrier 7, how to punch.

Each applied first register mark 15 on the carrier 7 shows that on or in the neighbourhood of this register mark 15 a hole has to be punched. According to a preferred embodiment the first register marks 15 are applied on the carrier 7 at a distance that each time comprises at the most 50 mm from the hole to punch. The first register marks 15 are preferably applied during the exposition of carrier 7. Preferably at least one hole to punch is associated with each first register mark 15, which offers the possibility to couple the holes with the picture to be applied and no longer with the border of the carrier 7. A greater accuracy for the holes to be punched is hereby obtained. The application of the holes on the location indicated by the register marks 15 occurs by means of the punch element 4, 6.

The perforation of holes in the carrier 7 by application of the method according to the invention occurs now as follows. The carrier 7 is introduced in the punch machine 1 or manually placed in the punch machine 1 by means of a control device. If the punch machine 1 is provided to process different formats of carriers 7, the detection member and the perforation member are preset on the format of the carrier 7, by means of shifting in the direction of the arrow 12. Shifting in the direction of the arrow 12 occurs even when holes have to be punched in the side borders of the carrier 7.

Upon introduction of the carrier 7 the detector 3 first recognises an indicator 21 that is applied on the front of the carrier 7. This indicator 21 then supplies the origin of the reference frame of the carrier 7. In the example represented in figures 5 and 6 the indicator 21 is formed of a right angle line, but other embodiments are also possible. The codeword 18 is for example applied in the continuation of the indicator 21, which simplifies the detection of the location of the codeword 18. By the square configuration of the indicator 21 the detection in two directions is possible. Once the detector recognised the indicator 21, the codeword 18 is easily found. By using a reference frame whereof the indicator 21 supplies the origin the codeword 18 is preferably applied on a predetermined location whereof the co-ordinates are then known by the unit. The read-member 14 is then positioned on said location. It is not necessary to apply the codeword 18 on the carrier 7 itself. When for example the punch machine 1 and the developing machine 2 are connected with each other it is also possible to present the codeword 18 at the entry of the punch machine 1, for example as a digital word, so that a data processing unit (not represented in the figure) of the punch machine 1 thus receives the codeword information and can process further. The codeword 18 is then generated for example by a central data processing unit and presented there where the information is important, such as for example to the punch machine 1.

After reading or receiving the codeword 18 the gathered information therein is processed in order to start the perforation process and amongst others to drive the perforation member. If the codeword 18 comprises position information about the location of the first register marks 15 then the latter is used to determine the carrier throughput speed between successive perforation locations. Indeed from this position information is known where the first register marks 15 are applied and thus where the perforations have to be applied. The carrier 7 may then be displaced with a somewhat greater speed in order to quickly come near the first register mark 15 but as already earlier noticed this speed can not be greater than the supply speed. Once near the first register mark 15 precise positioning can take place.

When the codeword information also comprises the dimension of the carrier 7 then the latter is used to displace at least one unit 10 and/or 11 of the punch machine 1 in order to let the position of the perforation member correspond with the dimension of the carrier 7. From the information relating to the dimension a position for the unit 10 and/or 11 is then determined and the latter is brought to this position. All this occurs under control of the data processing unit that knows the actual position of the perforation member.

Upon on-line punching, the carrier 7 is transported through the punch machine 1 till a first and a second register mark 15, 16 on the left or right longitudinal wall are detected by the detector 3 or 5. The detectors 3, 5 and/or the carrier 7 are shifted in such a way that the detector 3 and/or 5 is positioned with respect to the register marks 15, 16. By manually placing the carrier 7 in the machine 1 the units 10 and 11 are each time shifted in the longitudinal or transverse direction in order to position the detectors 3 and/or 5 with respect to the carrier 7.

By means of the first and second register mark 15, 16 the carrier 7 is thus positioned with respect to the detector 3 and/or 5. When this positioning has taken place the transport of a machine 1 with on-line supply is temporarily interrupted in order to refine the positioning. After that the carrier 7 is positioned with respect to the detection member the punch element 4 and/or 6 is activated in order to select a perforation head and to punch one or more holes in the carrier 7. By on-line supply the punching also occurs with an immobile carrier 7.

In order to take the position of the perforation head in the punch element 4, 6 into account when several heads occupy a fixed location in the punch element 4,6, in such a situation this fixed position is taken into consideration by applying a first register mark 15 on the carrier 7. The position of the register mark 15 on the carrier 7 is then determined in such a way that the selected perforation head will apply the perforation on the adequate location. Indeed the distance between the detection member and each of the perforation heads is different upon fixed position of the heads so that these different distances have to be taken into account upon applying the first register mark 15. This occurs by means of parameter setting.

By applying the perforation on the location supplied by the register mark 15, after the positioning of the carrier 7 and the detector 3 and/or 5 having taken place by means of the register mark 15, the selected perforation head is positioned on the first register mark 15. This occurs by means of rotation or translation dependent on the chosen structure of the different punch elements 4, 6.

When the punch elements 4, 6 are applied on a distance of at the most 50 mm from their detectors 3, 5 the holes are also applied within this distance from the first register marks 15 recognised by the detectors 3, 5. Since information about the format of the hole to be punched is taken from the codeword 18, this information is used to select a corresponding perforation head in function thereof. The chosen perforation head is then selected, before starting the perforation. In figure 4 different formats 17 (shapes) of holes are represented. This selection occurs under control of the data processing unit that sends an activation signal to the selected perforation head and subsequently positions the latter with respect to the first register mark 15 before starting the punching.

By now associating the register mark 15 with the holes that are to be applied in the neighbourhood thereof a great flexibility is offered because now the holes are associated with the picture and not only with the carrier 7. Because of the small distance, at the most 50 mm between the register mark 15 and the hole or holes, temperature influences or humidity influences have almost no effect on the accuracy with which the holes are applied. The distance is indeed too small to have any influence. In this way also the chance that a carrier 7 be rejected because the holes have somewhat shifted due to temperature or humidity are substantially reduced.

## Claims

1. A method for applying perforations in a printed or exposed carrier (7), wherein at least a first register mark (15) and a second register mark (16) are applied on the carrier (7), and wherein the carrier (7) and a perforation member are positioned with respect to each other by means of the first register mark (15) and the second register mark (16), whereafter at least one perforation is applied in the carrier (7) by means of the perforation member, characterised in that a codeword (18), which indicates for each perforation to be applied the format of that perforation to be applied is read before the perforation is applied and wherein after reading the codeword (18) a perforation head is selected from the perforation member which corresponds with the format (17) for the perforation to be applied indicated in the codeword (18).

2. A method as claimed in claim 1, characterised in that for each perforation to be applied a position information is each time present in the codeword (18), which position information indicates where the perforation has to be applied.

3. A method as claimed in claim 1 or 2, characterised in that in the codeword information relating to the kind of carrier (7) is recorded.

4. A method as claimed in any one of the claims 1 to 3, characterised in that said codeword (18) is applied on the carrier (7).

5. A method as claimed in any one of the claims 1 to 4, characterised in that said first register mark (15) is each time applied on a distance of at the most 50 mm of the perforation to be applied.

6. A method as claimed in claim 4, characterised in that at the beginning of the carrier (7) an indicator (21) is applied which indicates the origin of a reference frame of the carrier (7) and wherein the codeword (18) is applied on a predetermined location with respect to that reference frame, and wherein upon introducing the carrier (7) said indicator (21) is recognized before reading the codeword (18).

7. A method as claimed in any one of the claims 1 to 6, characterized in that said carrier (7) is on-line supplied and that the supply speed of the carrier (7) is determined, and wherein the speed at which the perforations are applied on successive locations in the carrier (7) is the most set equal to the supply speed.

8. A method as claimed in claim 2, characterised in that from said position information a carrier throughput speed for the transport of the carrier (7) between two successive perforation locations is determined.

9. A device for applying perforations in a printed or exposed carrier (7) comprising
a perforation member,
a supply opening for supplying the carrier (7),
as well as a detection member provided for detecting a first register mark (15) and a second register mark (16) applied on the carrier (7) and further for positioning the carrier (7) and the perforation member with respect to each other, characterised in that the device comprises
a codeword read-member (14) provided for reading a codeword (18) indicating the format (17) of the perforation to be applied, the perforation member comprising at least two perforation heads, each adapted to apply a hole in the carrier (7) which is of a format (17) differing from the format which can be applied by using the other perforation head(s), which are selectable under control of the codeword (18),
a data processing unit to which the codeword read-member (14) can transmit the codeword (18), the data processing unit being adapted to control the perforation member such that the carrier (7) is perforated using a selected one of the perforation heads, the selection being carried by processing of the codeword (18) in the data processing unit.

10. A device as claimed in claim 9, characterized in that it comprises two punch elements of which at least one is displaceable in transverse direction with respect to the carrier's transport direction.

## Patentansprüche

1. Verfahren zum Ausbilden von Perforationen in einem gedruckten oder belichteten Träger (7), wobei mindestens eine erste Registermarke (15) und eine zweite Registermarke (16) auf dem Träger (7) aufgebracht werden, und wobei der Träger (7) und ein Perforationsglied mittels der ersten Registermarke (15) und der zweiten Registermarke (16) bezüglich einander positioniert werden, wonach mindestens eine Perforation mittels des Perforationsglieds in dem Träger (7) ausgebildet wird, dadurch gekennzeichnet, daß ein Codewort (18), das für jede auszubildende Perforation das Format dieser auszubildenden Perforation angibt, vor dem Ausbilden der Perforation gelesen wird, und wobei nach dem Lesen des Codeworts (18) ein Perforationskopf von dem Perforationsglied gewählt wird, das dem in dem Codewort (18) angegebenen Format (17) der auszubildenden Perforation entspricht.

2. Verfahren nach Anspruch 1, dadurch gekennzeichnet, daß für jede auszubildende Perforation jedesmal eine Positionsinformation im Codewort (18) vorhanden ist, wobei die Positionsinformation anzeigt, wo die Perforation ausgebildet werden muß.

3. Verfahren nach Anspruch 1 oder 2, dadurch gekennzeichnet, daß in dem Codewort die Art des Trägers (7) betreffende Informationen aufgezeichnet sind.

4. Verfahren nach einem der Ansprüche 1 bis 3, dadurch gekennzeichnet, daß das Codewort (18) auf dem Träger (7) aufgebracht wird.

5. Verfahren nach einem der Ansprüche 1 bis 4, dadurch gekennzeichnet, daß die erste Registermarke (15) jedesmal in einem Abstand von höchstens 50 mm von der auszubildenden Perforation aufgebracht wird.

6. Verfahren nach Anspruch 4, dadurch gekennzeichnet, daß am Beginn des Trägers (7) ein Indikator (21) aufgebracht wird, der den Anfangspunkt eines Bezugsrahmens des Trägers (7) anzeigt, und wobei das Codewort (18) an einer vorbestimmten Stelle bezüglich dieses Bezugsrahmens aufgebracht wird, und wobei der Indikator (21) bei der Einführung des Trägers (7) vor dem Lesen des Codeworts (18) erkannt wird.

7. Verfahren nach einem der Ansprüche 1 bis 6, dadurch gekennzeichnet, daß der Träger (7) online zugeführt wird und die Zuführgeschwindigkeit des Trägers (7) festgelegt ist, und wobei die Geschwindigkeit, mit der die Perforationen an aufeinanderfolgenden Stellen im Träger (7) ausgebildet werden, höchstens gleich der Zuführgeschwindigkeit eingestellt ist.

8. Verfahren nach Anspruch 2, dadurch gekennzeichnet, daß aus den Positionsinformationen eine Trägerdurchsatzgeschwindigkeit für die Beförderung des Trägers (7) zwischen zwei aufeinanderfolgenden Perforationsstellen bestimmt wird.

9. Vorrichtung zum Ausbilden von Perforationen in einem gedruckten oder belichteten Träger (7), mit
einem Perforationsglied,
einer Zu£ühröffnung zur Zuführung des Trägers (7),
sowie einem zur Erfassung einer ersten Registermarke (15) und einer zweiten Registermarke (16), die auf dem Träger (7) aufgebracht sind, und weiterhin zur Positionierung des Trägers (7) und des Perforationsglieds bezüglich einander vorgesehenen Erfassungsglied,
dadurch gekennzeichnet, daß die Vorrichtung folgendes umfaßt:
ein Codewort-Leseglied (14), das zum Lesen eines das Format (17) der auszubildenden Perforation anzeigenden Codeworts (18) vorgesehen ist, wobei das Perforationsglied mindestens zwei Perforationsköpfe umfaßt, die jeweils so ausgeführt sind, daß sie ein Loch in dem Träger (7) ausbilden, dessen Format (17) sich von dem Format unterscheidet, das durch Verwendung des anderen Perforationskopfs bzw. der anderen Perforationsköpfe ausgebildet werden kann, die unter Steuerung des Codeworts (18) auswählbar sind,
eine Datenverarbeitungseinheit, an die das Codewort-Leseglied (14) das Codewort (18) senden kann, wobei die Datenverarbeitungseinheit so ausgeführt ist, daß sie das Perforationsglied so steuern kann, daß der Träger (7) unter Verwendung eines ausgewählten der Perforationsköpfe perforiert wird, wobei die Auswahl durch Verarbeitung des Codeworts (18) in der Datenverarbeitungseinheit durchgeführt wird.

10. Vorrichtung nach Anspruch 9, dadurch gekennzeichnet, daß sie zwei Stanzelemente umfaßt, von denen mindestens eines in Querrichtung bezüglich der Beförderungsrichtung des Trägers verschiebbar ist.

## Revendications

1. Procédé pour effectuer des perforations dans un support imprimé ou exposé (7), dans lequel au moins une première marque d'alignement (15) et une deuxième marque d'alignement (16) sont appliquées sur le support (7), et dans lequel le support (7) et un organe de perforation sont positionnés l'un par rapport à l'autre au moyen de la première marque d'alignement (15) et de la deuxième marque d'alignement (16), après quoi au moins une perforation est effectuée dans le support (7) au moyen de l'organe de perforation, caractérisé en ce qu'un mot-code (18), qui indique, pour chaque perforation à effectuer, le format de cette perforation à effectuer, est lu avant que la perforation ne soit effectuée, et dans lequel, après la lecture du mot-code (18), une tête de perforation est sélectionnée dans l'organe de perforation, correspondant au format (17) pour la perforation à effectuer, indiqué dans le mot-code (18).

2. Procédé selon la revendication 1, caractérisé en ce que pour chaque perforation à effectuer, une information de position est présente à chaque fois dans le mot-code (18), laquelle information de position indique où la perforation doit être effectuée.

3. Procédé selon la revendication 1 ou 2, caractérisé en ce que l'information du mot-code correspondant au type de support (7) est enregistrée.

4. Procédé selon l'une quelconque des revendications 1 à 3, caractérisé en ce que ledit mot-code (18) est appliqué sur le support (7).

5. Procédé selon l'une quelconque des revendications 1 à 4, caractérisé en ce que ladite première marque d'alignement (15) est à chaque fois appliquée à une distance d'au plus 50 mm de la perforation à effectuer.

6. Procédé selon la revendication 4, caractérisé en ce qu'un indicateur (21) est prévu au début du support (7), indiquant l'origine d'un cadre de référence du support (7) et dans lequel le mot-code (18) est appliqué en un emplacement prédéterminé par rapport à ce cadre de référence, et dans lequel, lors de l'introduction du support (7), ledit indicateur (21) est reconnu avant la lecture du mot-code (18).

7. Procédé selon l'une quelconque des revendications 1 à 6, caractérisé en ce que ledit support (7) est alimenté en ligne, et en ce que la vitesse d'alimentation du support (7) est déterminée, et dans lequel la vitesse à laquelle les perforations sont effectuées en des emplacements successifs du support (7) est au plus ajustée comme étant égale à la vitesse d'alimentation.

8. Procédé selon la revendication 2, caractérisé en ce qu'à partir de ladite information de position, on détermine une vitesse d'avance du support pour le transport du support (7) entre deux emplacements de perforation successifs.

9. Dispositif pour effectuer des perforations dans un support (7) imprimé ou exposé, comprenant
un organe de perforation,
une ouverture d'alimentation pour l'alimentation du support (7),
ainsi qu'un organe de détection prévu pour détecter une première marque d'alignement (15) et une deuxième marque d'alignement (16) appliquées sur le support (7), et en outre pour positionner le support (7) et l'organe de perforation l'un par rapport à l'autre, caractérisé en ce que le dispositif comprend
un organe de lecture (14) d'un mot-code prévu pour lire un mot-code (18) indiquant le format (17) de la perforation à effectuer, l'organe de perforation comprenant au moins deux têtes de perforation, chacune étant adaptée pour effectuer un trou dans le support (7), qui a un format (17) différent du format qui peut être obtenu en utilisant l'autre ou les autres têtes de perforation, qui peuvent être sélectionnées en fonction du mot-code (18),
une unité de traitement des données à laquelle l'organe de lecture (14) du mot-code peut transmettre le mot-code (18), l'unité de traitement des données étant adaptée pour commander l'organe de perforation de telle sorte que le support (7) soit perforé en utilisant une tête sélectionnée parmi les têtes de perforation, la sélection étant effectuée en traitant le mot-code (18) dans l'unité de traitement des données.

10. Dispositif selon la revendication 9, caractérisé en ce qu'il comprend deux éléments de poinçonnage dont au moins un est susceptible d'être déplacé dans la direction transversale par rapport à la direction de transport du support.
